# EUROPEAN PATENT APPLICATION

(11) **EP 4 848 921 A1**
(43) Date of publication of application: **02.12.2026**
(21) Application number: 25789268.7
(22) Date of filing: 13.03.2025
(51) Int. Cl.: H10B 12/00

(54) **METHOD FOR MANUFACTURING SEMICONDUCTOR STRUCTURE AND SEMICONDUCTOR STRUCTURE**

(30) Priority: 17.04.2024 CN 202410465795
(71) Applicant: CXMT Corporation, Hefei, Anhui 230601 (CN)
(72) Inventor: ZHANG, Qi, Hefei, Anhui 230601 (CN); LIU, Liwan, Hefei, Anhui 230601 (CN); LIU, Xiaotao, Hefei, Anhui 230601 (CN); LIN, Yanbing, Hefei, Anhui 230601 (CN)
(74) Representative: Gulde & Partner
(86) International application number: PCT/CN2025/082244
(87) International publication number: WO 2025/218398

(57) **Abstract**

Disclosed are a method for manufacturing a semiconductor structure and a semiconductor structure. The method includes: providing a base substrate, where the base substrate is provided with active pillars and isolation layers spaced apart along a first direction, the active pillars and the isolation layers all extend along a second direction, the first direction is parallel to the surface of the base substrate, the second direction is parallel to the thickness direction of the base substrate, and the second direction is perpendicular to the first direction; removing a portion of each of the isolation layers to form a first groove; depositing a first dielectric layer at least on side walls of the first groove to form a second groove; forming a first metal layer, where the first metal layer directly covers at least the active pillars; performing a heat treatment to form conductive structures, where the first dielectric layer covers side walls of each of the conductive structures, the conductive structures extend along a third direction, and the third direction is perpendicular to the first direction and the second direction; and forming a second dielectric layer, where the second dielectric layer fills the second groove.

## Description

### CROSS-REFERENCE

This application claims priority to Chinese Patent Application No. 202410465795.7 filed on April 17, 2024 and entitled "METHOD FOR MANUFACTURING SEMICONDUCTOR STRUCTURE AND SEMICONDUCTOR STRUCTURE", the content of which is incorporated herein by reference in its entirety.

### TECHNICAL FIELD

Embodiments of the present disclosure relate to the field of semiconductors, and in particular, to a method for manufacturing a semiconductor structure and a semiconductor structure.

### BACKGROUND

A dynamic random access memory (dynamic random access memory, DRAM) is a type of semiconductor memory. Compared with a static memory, the DRAM has the advantages of a simpler structure, lower manufacturing costs, and higher capacity density. With the development of the semiconductor industry, semiconductor devices are becoming highly integrated, i.e., miniaturized. For highly integrated semiconductor devices, vertical channel transistors (VCTs) are taking the place of planar channel transistors.

However, the problems of low performance and a low yield of semiconductor memory devices still exist in the process of manufacturing vertical channel transistors, and how to improve the performance and the yield of semiconductor memory devices is an urgent technical problem to be solved at present.

### SUMMARY

Embodiments of the present disclosure provide a method for manufacturing a semiconductor structure and a semiconductor structure, which can at least help improve the performance and the yield of semiconductor memory devices.

According to some embodiments of the present disclosure, an aspect of the embodiments of the present disclosure provides a method for manufacturing a semiconductor structure, which includes:
providing a base substrate, where the base substrate is provided with active pillars and isolation layers spaced apart along a first direction, the active pillars and the isolation layers all extend along a second direction, the first direction is parallel to a surface of the base substrate, the second direction is parallel to a thickness direction of the base substrate, and the second direction is perpendicular to the first direction;
removing a portion of each of the isolation layers to form a first groove;
depositing a first dielectric layer at least on side walls of the first groove to form a second groove;
forming a first metal layer, where the first metal layer directly covers at least the active pillars;
performing a heat treatment to form conductive structures, where the first dielectric layer covers side walls of each of the conductive structures, the conductive structures extend along a third direction, and the third direction is perpendicular to the first direction and the second direction; and
forming a second dielectric layer, where the second dielectric layer fills the second groove.

In some embodiments, forming the first dielectric layer specifically includes:
forming a first dielectric material layer, where the first dielectric material layer covers the side walls and a bottom of the first groove, and a top of each of the active pillars; and
removing a portion of the first dielectric material layer on the top of the active pillar, where a remaining portion of the first dielectric material layer serves as the first dielectric layer.

In some embodiments, forming the first dielectric layer specifically includes:
forming a first dielectric material layer, where the first dielectric material layer covers the side walls and a bottom of the first groove, and a top of each of the active pillars; and
removing a portion of the first dielectric material layer on the top of the active pillar and at the bottom of the first groove, where a remaining portion of the first dielectric material layer serves as the first dielectric layer.

In some embodiments, the first metal layer fills up the second groove and covers the top of the active pillar.

In some embodiments, after the first dielectric material layer is formed and before the first metal layer is formed, the method further includes:
forming a second metal material layer, where the second metal material layer covers the first dielectric material layer and fills up the second groove; removing a portion of the second metal material layer and a portion of the first dielectric material layer, to expose the top of the active pillar, where a remaining portion of the second metal material layer serves as a second metal layer that is flush with the active pillar; and
forming the first metal layer on the top of the second metal layer and the active pillar.

In some embodiments, after the first dielectric material layer is formed and before the first metal layer is formed, the method further includes:
forming a third dielectric material layer, where the third dielectric material layer covers the first dielectric material layer and fills up the second groove; removing a portion of the third dielectric material layer and a portion of the first dielectric material layer, to expose the top of the active pillar, where a remaining portion of the third dielectric material layer serves as a third dielectric layer that is flush with the active pillar; and
forming the first metal layer on the top of the third dielectric layer and the active pillar.

In some embodiments, after the conductive structures are formed and before the second dielectric layer is formed, the method further includes:
removing the first metal layer, to re-expose the second groove.

In some embodiments, after the conductive structures are formed and before the second dielectric layer is formed, the method further includes:
removing the first metal layer and the second metal layer, to re-expose the second groove.

In some embodiments, after the conductive structures are formed and before the second dielectric layer is formed, the method further includes:
removing the first metal layer and the third dielectric layer, to re-expose the second groove.

In some embodiments, a dielectric constant of the first dielectric layer is less than a dielectric constant of each of the active pillars; and a depth of the first groove is greater than a depth of the conductive structure.

In some embodiments, the second dielectric layer has air gaps therein, and a depth of each of the air gaps in the second direction is greater than a depth of the conductive structure.

In some embodiments, a temperature for forming the first dielectric layer is higher than a temperature for the heat treatment, and a resistivity of the conductive structure is not greater than 20 µΩ·cm.

Another aspect of the embodiments of the present disclosure provides a semiconductor structure. The semiconductor structure includes:
a base substrate, where the base substrate is provided with active pillars and isolation layers spaced apart along a first direction, the active pillars and the isolation layers all extend along a second direction, the first direction is parallel to a surface of the base substrate, the second direction is parallel to a thickness direction of the base substrate, and the second direction is perpendicular to the first direction;
conductive structures, electrically connected to the active pillars, where the conductive structures extend along a third direction, and the third direction is perpendicular to the first direction and the second direction;
a first groove, located between adjacent conductive structures;
a second groove, located in the first groove;
a first dielectric layer, located between the first groove and the second groove and covering at least side walls of each of the conductive structures; and
a second dielectric layer, filling the second groove and covering a top of each of the conductive structures.

In some embodiments, a dielectric constant of the first dielectric layer is less than a dielectric constant of each of the active pillars; and a depth of the first groove is greater than a depth of the conductive structure.

In some embodiments, a resistivity of the conductive structure is not greater than 20 µΩ·cm.

In some embodiments, the second dielectric layer has air gaps therein, and a depth of each of the air gaps in the second direction is greater than a depth of the conductive structure.

According to the semiconductor structure and the manufacturing method therefor provided in some embodiments of the present disclosure, a portion of each of the isolation layers is removed to form a first groove; a first dielectric layer is deposited at least on the side walls of the first groove to form a second groove; a first metal layer is formed, where the first metal layer directly covers at least the active pillars; and the heat treatment is performed to form the conductive structures, where the first dielectric layer covers the side walls of each of the conductive structures. In this way, firstly, as the first dielectric layer covers the side walls of the conductive structure, the conductive structure can be protected, and the appearance of the conductive structure is prevented from being transformed. Secondly, the early coverage of the first dielectric layer in the process can prevent the conductive structure from being changed from a low resistance state to a high resistance state, such that the resistance of the conductive structure can be reduced. Thirdly, the parasitic capacitance between the conductive structures can be reduced due to a relatively low dielectric constant of the first dielectric layer. With the foregoing problems solved, the performance of the conductive structures and the yield of semiconductor devices can be improved.

### BRIEF DESCRIPTION OF DRAWINGS

One or more embodiments are exemplarily illustrated with reference to figures in the corresponding drawings, and these exemplary illustrations are not to be construed as limiting the embodiments. Unless expressly stated otherwise, the figures in the drawings do not constitute a limitation of scale. To more clearly illustrate the technical solutions in the embodiments of the present disclosure or conventional technology, a brief introduction to the drawings required to be used in the embodiments is given hereinafter. It is evident that the drawings described hereinafter are merely some embodiments of the present disclosure. For those of ordinary skill in the art, other drawings may be further obtained based on these drawings without creative effort.
FIG. 1A to FIG. 1E are process flowcharts showing various steps during the manufacturing of a semiconductor structure according to the related art;
FIG. 2A to FIG. 2J are process flowcharts showing a method for forming a semiconductor structure according to an embodiment of the present disclosure;
FIG. 3A to FIG. 3H are process flowcharts showing a method for forming a semiconductor structure according to yet another embodiment of the present disclosure;
FIG. 4A to FIG. 4H are process flowcharts showing a method for forming a semiconductor structure according to still another embodiment of the present disclosure;
FIG. 5A is a schematic structural diagram of a semiconductor structure according to an embodiment of the present disclosure;
FIG. 5B is a schematic structural diagram of a semiconductor structure according to another embodiment of the present disclosure; and
FIG. 5C is a schematic structural diagram of a semiconductor structure bonded to a wafer according to the present disclosure.

### DESCRIPTION OF EMBODIMENTS

Embodiments of the semiconductor structure and the manufacturing method therefor provided in the present disclosure are described in detail below with reference to the drawings.

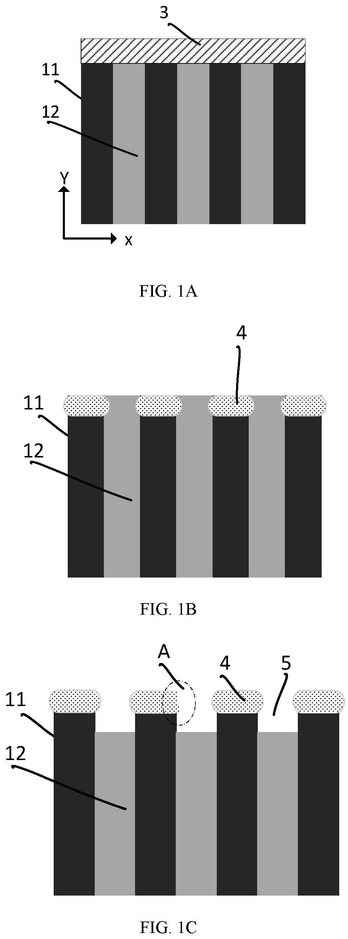

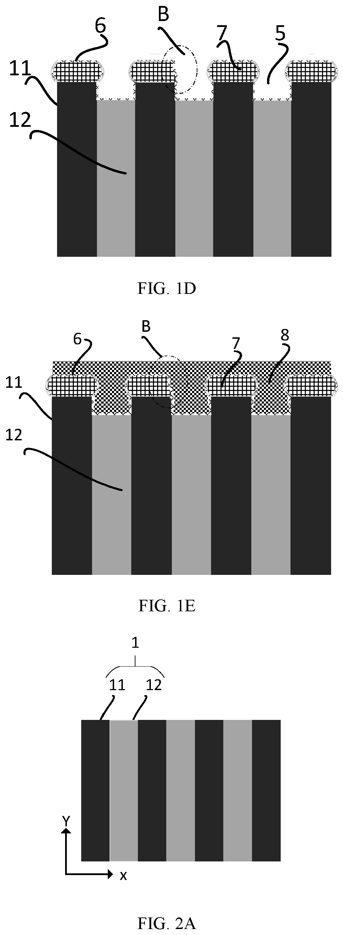

As shown in FIG. 1A to FIG. 1E, during the manufacturing of a semiconductor device in a related art, as shown in FIG. 1A, a first metal layer 3 is formed on active pillars 11 and isolation layers 12, and conductive structures 4 shown in FIG. 1B are formed after heat treatment. Since a metal layer expands when reacting with the active pillars, the finally formed conductive structures 4 each have a bigger-head shape as shown in the figure. The bigger-head shape can affect both the performance of the conductive structures and subsequent processes. Further, as shown in FIG. 1C, when a portion of each of the isolation layers 12 is being etched back to form a trench 5, as the side walls of the conductive structures 4 are not protected, the side wall of each of the conductive structures 4 of the bigger-head shape is etched to form a defect A, where only one defect is shown herein. The defect A may exist on the side wall of each of the conductive structures 4, and the defect A can affect the performance of the conductive structure 4. Moreover, as shown in FIG. 1D, after the conductive structures 4 are formed, the trench 5 is conformally covered by a first dielectric layer 6, and during the formation of the first dielectric layer 6, the defect A further leads to a defect B. Since a temperature for forming the first dielectric layer 6 is higher than a temperature for the heat treatment, the conductive structures 4 further react at the high temperature, to convert a material of the conductive structures 4 from a low resistance substance to a high resistance substance. That is, the conductive structures 4 in a low resistance state are converted into conductive structures 7 in a high resistance state. This leads to a higher resistance of the conductive structures 4, affecting the performance of the conductive structures 4, and increasing the contact resistance between the metal and the semiconductor. Finally, as shown in FIG. 1E, a second dielectric layer 8 is formed above the first dielectric layer 6 to fill up the trench 5, and the parasitic capacitance between conductive structures 4 is relatively large due to a high dielectric constant of the first dielectric layer 6.

Therefore, the present disclosure provides a method for forming a semiconductor structure and a semiconductor structure, which can protect the appearance of conductive structures, reduce defects, and reduce the resistance of the conductive structures and the parasitic capacitance between the conductive structures.

The embodiments of the present disclosure will be described in detail below with reference to the drawings. However, those of ordinary skill in the art can understand that, in the embodiments of the present disclosure, numerous technical details are set forth to enable readers to better understand the present disclosure. However, the technical solutions claimed by the present disclosure can also be implemented even without these technical details and the various changes and modifications based on the following embodiments.

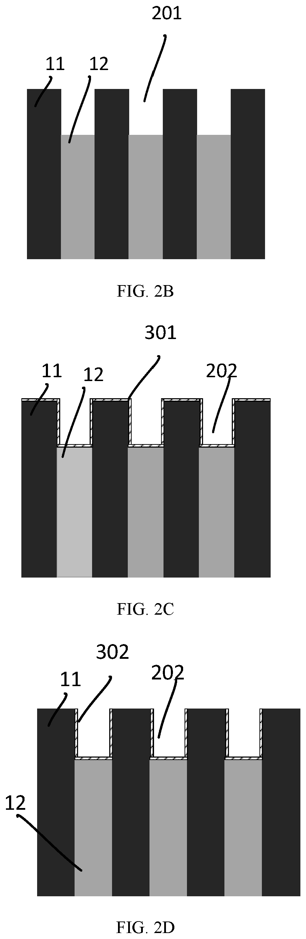

FIG. 2A to FIG. 2J are process flowcharts showing a method for forming a semiconductor structure according to an embodiment of the present disclosure. Referring to FIG. 2A and FIG. 2B, the method for forming a semiconductor structure according to the present disclosure includes the following steps: providing a base substrate 1, where the base substrate 1 is provided with active pillars 11 and isolation layers 12 spaced apart along a first direction X, the active pillars 11 and the isolation layers 12 all extend along a second direction Y, the first direction X is parallel to the surface of the base substrate 1, the second direction Y is parallel to the thickness direction of the base substrate 1, and the second direction Y is perpendicular to the first direction X; and removing a portion of each of the isolation layers 12 to form a first groove 201.

The material of the base substrate may be silicon (Si), germanium (Ge), silicon germanium (GeSi), or silicon carbide (SiC), or may be silicon-on-insulator (SOI) or germanium-on-insulator (GOI), or may be another material, for example, a group III-V compound, for example, gallium arsenide. The material of the base substrate in this embodiment is silicon. The base substrate is doped with specific impurity ions as needed, and the impurity ions may be N-type impurity ions or P-type impurity ions.

The present disclosure provides a method for forming the active pillars 11, and the forming method includes, but is not limited to, the following steps: forming a plurality of trenches in a semiconductor substrate by using a photoetching method; and filling the trenches with an isolation material to form the isolation layers 12, where the isolation material includes, but is not limited to, silicon oxide, silicon nitride, silicon oxynitride, or another suitable isolation material. In this embodiment, the isolation material is silicon oxide. A portion of the base substrate isolated by the isolation layers 12 is the active pillars 11. In this embodiment, as shown in FIG. 2A, the active pillars 11 and the isolation layers 12 are spaced apart along the first direction X, the first direction X is parallel to the surface of the base substrate 1, the active pillars 11 and the isolation layers 12 all extend along the second direction Y, and the second direction Y is parallel to the thickness direction of the base substrate 1.

The top surface of the first groove 201 is lower than the top surface of each of the active pillars 11, and the depth of the first groove 201 may be set based on specific process requirements.

Then, as shown in FIG. 2C to FIG. 2E, a first dielectric layer 302 is deposited at least on the side walls of the first groove 201 to form a second groove 202.

As shown in FIG. 2C and FIG. 2D, a specific method for forming the first dielectric layer 302 includes: forming a first dielectric material layer 301, where the first dielectric material layer 301 covers the side walls and the bottom of the first groove 201, and the top of each of the active pillars 11; and
removing a portion of the first dielectric material layer 301 on the top of the active pillar 11, where a remaining portion of the first dielectric material layer 301 serves as the first dielectric layer 302, and the first dielectric layer 302 covers the bottom of the first groove 201 and the side walls of the active pillar 11 that are exposed by the first groove 201.

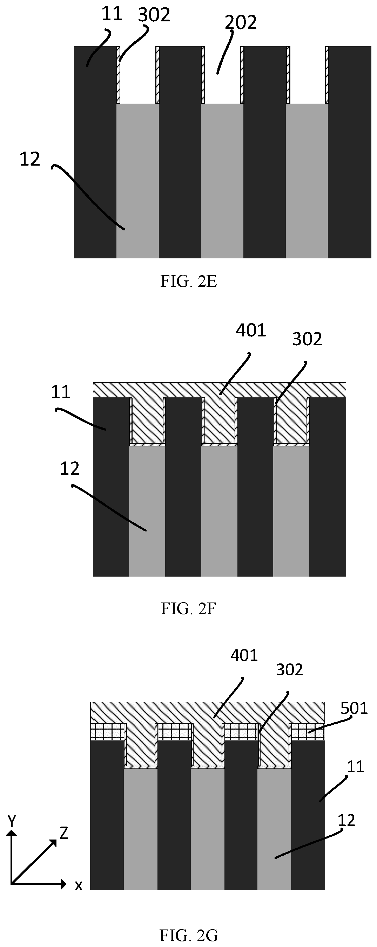

As shown in FIG. 2C and FIG. 2E, another specific method for forming the first dielectric layer 302 includes: forming a first dielectric material layer 301, where the first dielectric material layer 301 covers the side walls and the bottom of the first groove 201, and the top of each of the active pillars 11; and
removing a portion of the first dielectric material layer 301 on the top of the active pillar 11 and at the bottom of the first groove 201, where a remaining portion of the first dielectric material layer 301 serves as the first dielectric layer 302, and the first dielectric layer 302 covers only the side walls of the active pillar 11 that are exposed by the first groove 201.

Specifically, forming the first dielectric material layer 301 includes, but is not limited to, the following methods: One of an atomic layer deposition (ALD) process, a plasma enhanced atomic layer deposition (PEALD) process, a chemical vapor deposition (CVD) process, and a plasma enhanced chemical vapor deposition (PECVD) process may be used to form the first dielectric material layer 301.

As shown in FIG. 2D, for removing the portion of the first dielectric material layer 301 on the top of the active pillar 11, a chemical mechanical polishing (CMP) method may be used to polish and remove only the portion of the first dielectric material layer 301 on the top of the active pillar 11, while keeping the portion of the first dielectric material layer 301 on the side walls and at the bottom of the first groove 201; and as shown in FIG. 2E, for removing the portion of the first dielectric material layer 301 on the top of the active pillar 11 and at the bottom of the first groove 201, a dry etching process may be used to remove the portion of the first dielectric material layer 301 on the top of the active pillar 11 and at the bottom of the first groove 201 by adjusting etching angles, energy, and doses, while keeping only the portion of the first dielectric material layer 301 on the side walls of the first groove 201.

Then, as shown in FIG. 2F, a first metal layer 401 is formed, where the first metal layer 401 directly covers at least the active pillars 11. Specifically, forming the first metal layer 401 includes, but is not limited to, the following methods: One of an atomic layer deposition (ALD) process, a plasma enhanced atomic layer deposition (PEALD) process, a chemical vapor deposition (CVD) process, and a plasma enhanced chemical vapor deposition (PECVD) process may be used to form the first metal layer 401. The first metal layer 401 fills up the second groove 202 and covers the top of the active pillar 11. The first metal layer 401 includes, but is not limited to, the following materials: for example, one or more of tungsten (W), ruthenium (Ru), iridium (Ir), tantalum (Ta), titanium (Ti), platinum (Pt), molybdenum (Mo), and nickel (Ni). In this embodiment, the first metal layer 401 is optionally platinum-doped nickel (NiPt).

Then, as shown in FIG. 2G, a heat treatment is performed to form conductive structures 501, where the first dielectric layer 302 covers the side walls of each of the conductive structures 501, the conductive structures 501 extend along a third direction Z, and the third direction Z is perpendicular to the first direction X and the second direction Y. A specific process for performing the heat treatment to form the conductive structures includes, but is not limited to, the following methods: The heat treatment may be performed by a high-temperature rapid thermal processing (rapid thermal processing, RTP) process. Through the RTP process, the first metal layer 401 reacts with the active pillars 11 to form a metal silicide layer, and the metal silicide layer has a good electrical conductivity for forming the conductive structures 501 that are electrically connected to the active pillars 11.

As the first dielectric layer 302 covers at least the side walls of the active pillars 11, when the conductive structures 501 are being generated through the reaction between the first metal layer 401 and the active pillars 11, the first dielectric layer 302 protects the side walls of the active pillars 11, to prevent the defective bigger-head shape shown in FIG. 1C caused by expansion due to the reaction between the active pillars 11 and the first metal layer 401. In this way, the appearance of the side walls of the conductive structures 501 can be relatively vertical, improving the performance of the conductive structures 501, and facilitating subsequent processes.

In addition, a temperature for forming the first dielectric layer 302 is higher than a temperature for the heat treatment, where the temperature for forming the first dielectric layer 302 is higher than 500°C, and the temperature for the heat treatment is not higher than 500°C. As shown in FIG. 1C and FIG. 1D above, in the case that the conductive structures are formed before the first dielectric layer is formed, as the temperature for forming the first dielectric layer is higher than the temperature for the heat treatment, the conductive structures can further react at the high temperature, to convert a material of the conductive structures from a low resistance substance to a high resistance substance. That is, the conductive structures in a low resistance state are converted into conductive structures in a high resistance state. This leads to a higher resistance of the conductive structures, affecting the performance of the conductive structures. However, in the present application, the formation of the first dielectric layer 302 is prior to the formation of the conductive structures 501, that is, the first dielectric layer 302 is formed before the conductive structures 501 are formed, and the reaction of the first dielectric layer 302 at the high temperature does not affect the subsequent formation of the conductive structures 501, such that the material of the conductive structures 501 is not converted from the low resistance substance to the high resistance substance, thereby preventing the resistance of the conductive structures 501 from increasing, and improving the performance of the conductive structures 501.

Specifically, the conductive structures 501 may be made of one or more of titanium silicide (TiSi), tantalum silicide (TaSi), nickel silicide (NiSi), and cobalt silicide (CoSi). Optionally, the conductive structures 501 are made of nickel silicide (NiSi). Specifically, with poor thermal stability, NiSi starts to agglomerate at a temperature higher than 500°C, and low resistance NiSi starts to convert into high resistance NiSi2. Specifically, the resistivity of NiSi is not greater than 20 µΩ·cm, and the resistivity of NiSi2 ranges from 24 µΩ·cm to 30 µΩ·cm. The conversion of the NiSi film layer from low resistance NiSi to high resistance NiSi2 can seriously affect the contact characteristics between the metal and the semiconductor, sharply increasing the contact resistance and lowering the performance of the device. Therefore, according to the present application, the first dielectric layer 302 with the high reaction temperature is formed before the conductive structures 501 are formed, to prevent the conductive structures 501 from being converted from low resistance NiSi to high resistance NiSi2, such that the resistance of the conductive structures 501 can be reduced, the contact resistance between the metal and the semiconductor can be further reduced, and the performance of the device can be improved.

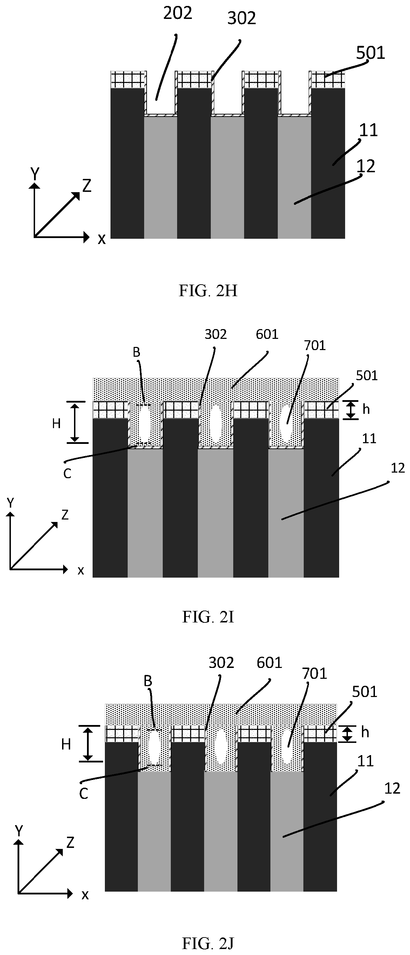

Then, as shown in FIG. 2H to FIG. 2J, a second dielectric layer 601 is formed, where the second dielectric layer 601 fills the second groove 202.

Specifically, as shown in FIG. 2H, after the conductive structures 501 are formed and before the second dielectric layer 601 is formed, the method further includes: removing the first metal layer 401, to re-expose the second groove 202. The first metal layer 401 may be removed by a wet etching process, or a portion of the first metal layer 401 on the top of each of the conductive structures 501 may be first removed by a CMP process, and a remaining portion of the first metal layer 401 may be removed by a dry etching process. When the first metal layer 401 is being removed, as the side walls of the conductive structures 501 are protected by the first dielectric layer 302, the side walls of the conductive structures 501 can be prevented from being etched, to prevent the defect A shown in FIG. 1C, such that the performance of the conductive structures 501 can be improved.

Specifically, as shown in FIG. 2I and FIG. 2J, the second dielectric layer 601 fills the re-exposed second groove 202, and the second dielectric layer 601 not only fills the second groove 202, but also covers the top of each of the conductive structures; and the second dielectric layer 601 includes, but is not limited to, silicon oxide, silicon nitride, silicon oxynitride, or another suitable isolation material. In this embodiment, the second dielectric layer 601 is silicon oxide. Specifically, forming the second dielectric layer 601 includes, but is not limited to, the following methods: One of an atomic layer deposition (ALD) process, a plasma enhanced atomic layer deposition (PEALD) process, a chemical vapor deposition (CVD) process, and a plasma enhanced chemical vapor deposition (PECVD) process may be used to form the second dielectric layer 601.

Specifically, in an embodiment, as shown in FIG. 2I, in the case that the first dielectric layer 302 covers the side walls and the bottom of the first groove 201, the second dielectric layer 601 covers the first dielectric layer 302 on the side walls and at the bottom of the first groove 201, and the second dielectric layer 601 fills the second groove 202 and covers the top of the conductive structure 501; or in another embodiment, as shown in FIG. 2J, in the case that the first dielectric layer 302 covers only the side walls of the first groove 201, the second dielectric layer 601 covers the first dielectric layer on the side walls of the first groove 201, and the second dielectric layer 601 fills the second groove 202 and covers the top of the conductive structure 501.

Specifically, the second dielectric layer 601 may or may not have air gaps therein. Optionally, as shown in FIG. 2I and FIG. 2J, the second dielectric layer 601 has air gaps 701 therein, and the depth of each of the air gaps 701 in the second direction Y is greater than the depth of the conductive structure 501. In the present application, the depth of the first groove 201 is greater than the depth of the conductive structure 501, making it possible that the depth of the air gap 701 in the second direction Y is greater than the depth of the conductive structure 501. The depth h of the conductive structure refers to the depth measured from the top surface of the conductive structure to the very bottom of the conductive structure. As shown in the figure, the air gap 701 is provided with a top part B and a bottom part C, the top part B of the air gap 701 is lower than the top surface of the conductive structure 501, but is higher than the bottom surface of the conductive structure 501, the bottom part C of the air gap 701 is lower than the bottom surface of the conductive structure 501, and the depth H of the air gap 701 refers to the height measured in a direction from a point parallel to the top surface of the conductive structure 501 toward the bottom part C of the air gap, as shown by H in FIG. 2I and FIG. 2J. Further, the size of the air gap 701 in the second direction Y is 2/3 to 3/4 of the depth of the second groove 202, and the maximum size of the air gap in the first direction X is 1/3 to 3/4 of the width of the second groove 202. This arrangement allows the air gap 701, as placed between the conductive structures 501, to reduce the parasitic capacitance between the conductive structures 501. In addition, the dielectric constant of the first dielectric layer 302 is less than the dielectric constant of each of the active pillars, and the material of the first dielectric layer 302 includes, but is not limited to, silicon oxide, silicon nitride, silicon oxynitride, carbon-doped silicon oxide, or another suitable material, where the first dielectric layer 302 may be carbon-doped silicon oxide in the embodiments of the present application; and the main material of the active pillar is silicon, where the dielectric constant of silicon is 11 to 12, the dielectric constant of the carbon-doped silicon oxide is about 4.5, and the dielectric constant of the first dielectric layer 302 is less than the dielectric constant of the active pillar, such that the parasitic capacitance of the semiconductor structure can be further reduced.

According to the embodiments of the present application, through process optimization and improvement, the first dielectric layer 302 with the high reaction temperature is formed before the conductive structures 501 are formed, to prevent the conductive structures 501 from being converted from low resistance NiSi to high resistance NiSi2, such that the resistance of the conductive structures 501 is reduced. Further, the first dielectric layer 302 can prevent the conductive structures 501 from having a bigger-head shape and from being further damaged during etching. Moreover, the dielectric constant of the first dielectric layer 302 is less than the dielectric constant of the active pillar 11, such that the parasitic capacitance of the device is reduced. To further reduce the parasitic capacitance, the air gap may be further arranged between the conductive structures 501. As the relative dielectric constant of the air is about 1, the air can be used as a good dielectric medium, to further reduce the parasitic capacitance between the conductive structures 501. Through all the foregoing improvements, the performance of the semiconductor device can be improved, and the yield of devices can be improved.

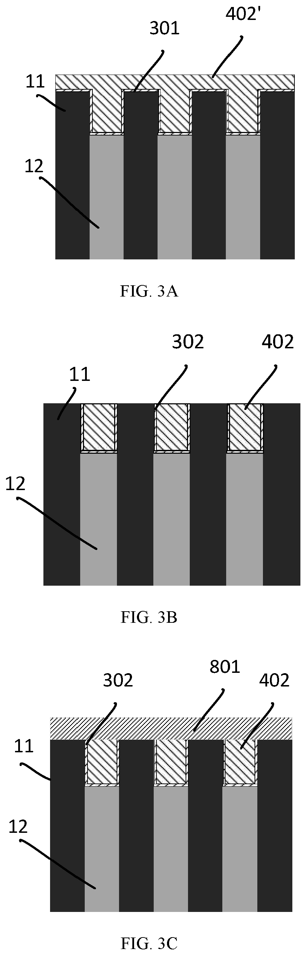

FIG. 3A to FIG. 3H are process flowcharts showing a method for forming a semiconductor structure according to yet another embodiment of the present disclosure. Some process steps in this embodiment are the same as or correspond to those of the foregoing embodiment. Therefore, for the content the same as or corresponding to those of the foregoing embodiment, reference can be made to the corresponding descriptions in the foregoing embodiment, and specifically, reference can be made to FIG. 2A to FIG. 2E for illustration. The method for forming a semiconductor structure according to the present disclosure includes the following steps: providing a base substrate 1, where the base substrate 1 is provided with active pillars 11 and isolation layers 12 spaced apart along a first direction X, the active pillars 11 and the isolation layers 12 all extend along a second direction Y, the first direction X is parallel to the surface of the base substrate 1, the second direction Y is parallel to the thickness direction of the base substrate 1, and the second direction Y is perpendicular to the first direction X; removing a portion of each of the isolation layers 12 to form a first groove 201; and depositing a first dielectric layer 302 at least on the side walls of the first groove 201 to form a second groove 202. A specific method for forming the first dielectric layer 302 may include: first forming a first dielectric material layer 301, where the first dielectric material layer 301 covers the side walls and the bottom of the first groove 201, and the top of each of the active pillars 11. As shown in FIG. 2C and FIG. 2D, a specific method for forming the first dielectric layer 302 includes: forming a first dielectric material layer 301, where the first dielectric material layer 301 covers the side walls and the bottom of the first groove 201, and the top of each of the active pillars 11; and removing a portion of the first dielectric material layer 301 on the top of the active pillar 11, where a remaining portion of the first dielectric material layer 301 serves as the first dielectric layer 302, and the first dielectric layer 302 covers the bottom of the first groove 201 and the side walls of the active pillar 11 that are exposed by the first groove 201. As shown in FIG. 2C and FIG. 2E, another specific method for forming the first dielectric layer 302 includes: forming a first dielectric material layer 301, where the first dielectric material layer 301 covers the side walls and the bottom of the first groove 201, and the top of each of the active pillars 11; and removing a portion of the first dielectric material layer 301 on the top of the active pillar 11 and at the bottom of the first groove 201, where a remaining portion of the first dielectric material layer 301 serves as the first dielectric layer 302, and the first dielectric layer 302 covers only the side walls of the active pillar 11 that are exposed by the first groove 201. For the foregoing steps, reference can be made to FIG. 2A to FIG. 2E.

The main differences in the yet another embodiment of the present disclosure are described in detail with reference to the drawings. As shown in FIG. 3A to FIG. 3C, a first metal layer 801 is formed. After the first dielectric material layer 301 is formed and before the first metal layer 801 is formed, the method further includes: as shown in FIG. 3A, forming a second metal material layer 402', where the second metal material layer 402' covers the first dielectric material layer 301 and fills up the second groove 202; and as shown in FIG. 3B, removing a portion of the second metal material layer 402' and a portion of the first dielectric material layer 301, to expose the top of the active pillar 11, where a remaining portion of the second metal material layer 402' serves as a second metal layer 402 that is flush with the active pillar 11, and a remaining portion of the first dielectric material layer 301 serves as the first dielectric layer 302 that covers at least the side walls of the active pillar 11. As shown in FIG. 3C, the first metal layer 801 is then formed on the top of the second metal layer 402 and the active pillar 11. The first metal layer 801 and the second metal layer 402 may be made of the same or different materials, and the first metal layer 801 and the second metal layer 402 include, but are not limited to, the following materials: for example, one or more of tungsten (W), ruthenium (Ru), iridium (Ir), tantalum (Ta), titanium (Ti), platinum (Pt), molybdenum (Mo), and nickel (Ni). In this embodiment, the first metal layer 801 is optionally platinum-doped nickel (NiPt).

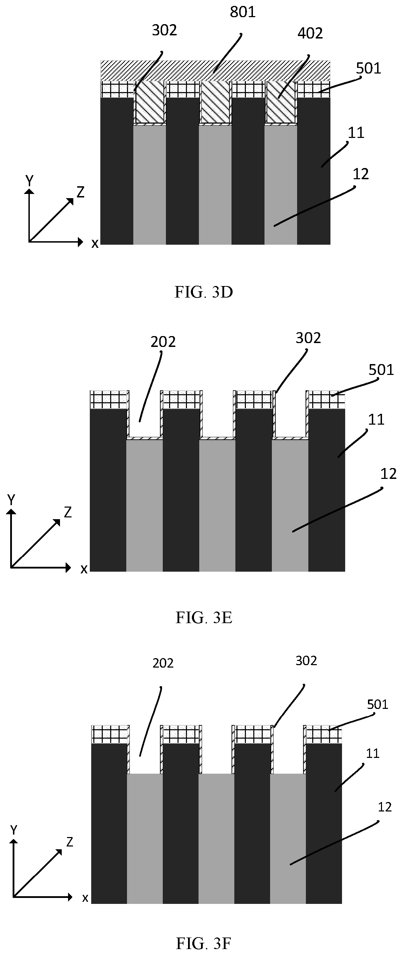

Then, as shown in FIG. 3D, a heat treatment is performed to form conductive structures 501. As the first dielectric layer 302 covers at least the side walls of the active pillars 11 exposed by the first groove, when the conductive structures 501 are being generated through the reaction between the first metal layer 801 and the active pillars 11, the first dielectric layer 302 protects the side walls of the active pillars 11, to prevent the defective bigger-head shape shown in FIG. 1C caused by expansion due to the reaction between the active pillars 11 and the first metal layer 801. In this way, the appearance of the side walls of the conductive structures 501 can be relatively vertical, improving the performance of the conductive structures 501, and facilitating subsequent processes.

As a temperature for forming the first dielectric layer 302 is higher than a temperature for the heat treatment, specifically, the temperature for forming the first dielectric layer 302 is higher than 500°C, and the temperature for the heat treatment is not higher than 500°C. As shown in FIG. 1C and FIG. 1D above, in the case that the conductive structures are formed before the first dielectric layer is formed, as the temperature for forming the first dielectric layer is higher than the temperature for the heat treatment, the conductive structures can further react at the high temperature, to convert a material of the conductive structures from a low resistance substance to a high resistance substance. That is, the conductive structures in a low resistance state are converted into conductive structures in a high resistance state. This leads to a higher resistance of the conductive structures, affecting the performance of the conductive structures. However, in the embodiments of the present application, the formation of the first dielectric layer 302 is prior to the formation of the conductive structures 501, that is, the first dielectric layer 302 is formed before the conductive structures 501 are formed, and the reaction of the first dielectric layer 302 at the high temperature does not affect the subsequent formation of the conductive structures 501, such that the material of the conductive structures 501 is not converted from the low resistance substance to the high resistance substance, thereby preventing the resistance of the conductive structures 501 from increasing, and improving the performance of the conductive structures 501.

Specifically, the conductive structures 501 may be made of one or more of titanium silicide (TiSi), tantalum silicide (TaSi), nickel silicide (NiSi), and cobalt silicide (CoSi). Optionally, the conductive structures 501 are made of nickel silicide (NiSi). Specifically, with poor thermal stability, NiSi starts to agglomerate at a temperature higher than 500°C, and low resistance NiSi starts to convert into high resistance NiSi2. Specifically, the resistivity of NiSi is not greater than 20 µΩ·cm, and the resistivity of NiSi2 ranges from 24 µΩ·cm to 30 µΩ·cm. The conversion of the NiSi thin film from low resistance NiSi to high resistance NiSi2 can seriously affect the contact characteristics between the metal and the semiconductor, causing a sharp increase in the contact resistance and lowering the performance of the device. Therefore, according to the present application, the first dielectric layer 302 with the high reaction temperature is formed before the conductive structures 501 are formed, to prevent the conductive structures 501 from being converted from low resistance NiSi to high resistance NiSi2, such that the resistance of the conductive structures 501 can be reduced, the contact resistance between the metal and the semiconductor can be further reduced, and the performance of the device can be improved.

Then, as shown in FIG. 3E and FIG. 3F, after the conductive structures 501 are formed, the method further includes: removing the first metal layer 801 and the second metal layer 402, to expose the second groove 202. Specifically, as shown in FIG. 3E, the first metal layer 801 and the second metal layer 402 may be removed by a wet etching process, and as shown in FIG. 3F, after the first metal layer 801 and the second metal layer 402 are removed, a portion of the first dielectric layer 302 at the bottom of the second groove 202 may be further removed, where a remaining portion of the first dielectric layer 302 covers only the side walls of the second groove 202, the first dielectric layer 302 covers the side walls of the conductive structures 501, and the depth of the first dielectric layer 302 in the second direction Y is greater than the depth of the conductive structure 501 in the second direction Y.

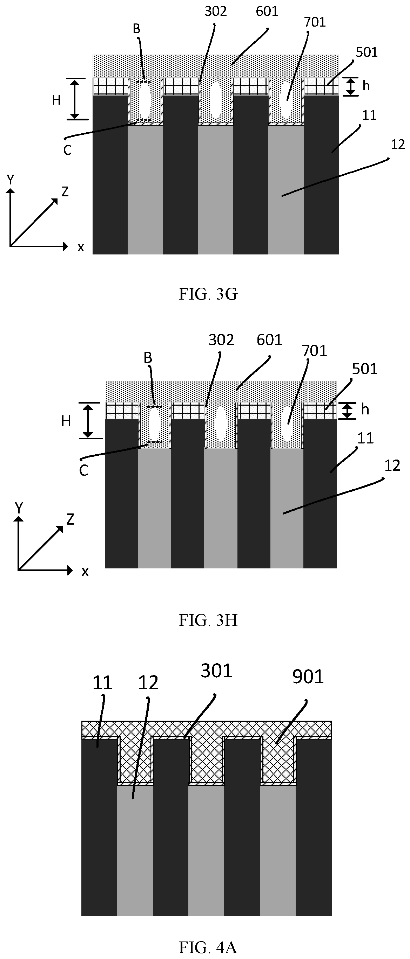

Then, as shown in FIG. 3G and FIG. 3H, a second dielectric layer 601 fills the second groove, and the second dielectric layer 601 not only fills the second groove 202, but also covers the top of the conductive structure 501. As shown in FIG. 3G, the first dielectric layer 302 is provided between the second dielectric layer 601 and each of the isolation layers 12; and as shown in FIG. 3H, the first dielectric layer 302 is not provided between the second dielectric layer 601 and the isolation layer 12, that is, the second dielectric layer 601 is in direct contact with the isolation layer 12.

Specifically, the second dielectric layer 601 may or may not have air gaps therein. Optionally, as shown in FIG. 3G and FIG. 3H, the second dielectric layer 601 has air gaps 701 therein, and the depth of each of the air gaps 701 in the second direction Y is greater than the depth of the conductive structure 501. In the present application, the depth of the first groove 201 is greater than the depth of the conductive structure 501, making it possible that the depth of the air gap 701 in the second direction Y is greater than the depth of the conductive structure 501. The depth h of the conductive structure refers to the depth measured from the top surface of the conductive structure to the very bottom of the conductive structure. As shown in the figure, the air gap 701 is provided with a top part B and a bottom part C, the top part B of the air gap 701 is lower than the top surface of the conductive structure 501, but is higher than the bottom surface of the conductive structure 501, the bottom part C of the air gap 701 is lower than the bottom surface of the conductive structure 501, and the depth H of the air gap 701 refers to the height measured in a direction from a point parallel to the top surface of the conductive structure 501 toward the bottom part C of the air gap, as shown by H in FIG. 3G and FIG. 3H. Further, the size of the air gap 701 in the second direction Y is 2/3 to 3/4 of the depth of the second groove 202, and the maximum size of the air gap in the first direction X is 1/3 to 3/4 of the width of the second groove 202. This arrangement allows the air gap 701, as placed between the conductive structures 501, to reduce the parasitic capacitance between the conductive structures 501. In addition, the dielectric constant of the first dielectric layer 302 is less than the dielectric constant of each of the active pillars, and the material of the first dielectric layer 302 includes, but is not limited to, silicon oxide, silicon nitride, silicon oxynitride, carbon-doped silicon oxide, or another suitable material, where the first dielectric layer 302 may be carbon-doped silicon oxide in the embodiments of the present application; and the main material of the active pillar is silicon, where the dielectric constant of silicon is 11 to 12, the dielectric constant of the carbon-doped silicon oxide is about 4.5, and the dielectric constant of the first dielectric layer 302 is less than the dielectric constant of the active pillar, such that the parasitic capacitance of the semiconductor structure can be further reduced.

According to the embodiments of the present application, through process optimization and improvement, the first dielectric layer 302 with the high reaction temperature is formed before the conductive structures 501 are formed, to prevent the conductive structures 501 from being converted from low resistance NiSi to high resistance NiSi2, such that the resistance of the conductive structures 501 is reduced. Further, the first dielectric layer 302 can prevent the conductive structures 501 from having a bigger-head shape and from being further damaged during etching. Moreover, the dielectric constant of the first dielectric layer 302 is less than the dielectric constant of the active pillar 11, such that the parasitic capacitance of the device is reduced. To further reduce the parasitic capacitance, the air gap may be further arranged between the conductive structures 501. As the relative dielectric constant of the air is about 1, the air can be used as a good dielectric medium, to further reduce the parasitic capacitance between the conductive structures 501. Through all the foregoing improvements, the performance of the semiconductor device can be improved, and the yield of devices can be improved.

FIG. 4A to FIG. 4H are process flowcharts showing a method for forming a semiconductor structure according to still another embodiment of the present disclosure. Some process steps in this embodiment are the same as or correspond to those of the foregoing embodiment. Therefore, for the content the same as or corresponding to those of the foregoing embodiment, reference can be made to the corresponding descriptions in the foregoing embodiment, and specifically, reference can be made to FIG. 2A to FIG. 2E. The method for forming a semiconductor structure according to the present disclosure includes the following steps: providing a base substrate 1, where the base substrate 1 is provided with active pillars 11 and isolation layers 12 spaced apart along a first direction X, the active pillars 11 and the isolation layers 12 all extend along a second direction Y, the first direction X is parallel to the surface of the base substrate 1, the second direction Y is parallel to the thickness direction of the base substrate 1, and the second direction Y is perpendicular to the first direction X; removing a portion of each of the isolation layers 12 to form a first groove 201; and depositing a first dielectric layer 302 at least on the side walls of the first groove 201 to form a second groove 202. A specific method for forming the first dielectric layer 302 may include: first forming a first dielectric material layer 301, where the first dielectric material layer 301 covers the side walls and the bottom of the first groove 201, and the top of each of the active pillars 11. For the foregoing steps, reference can be made to FIG. 2A to FIG. 2E.

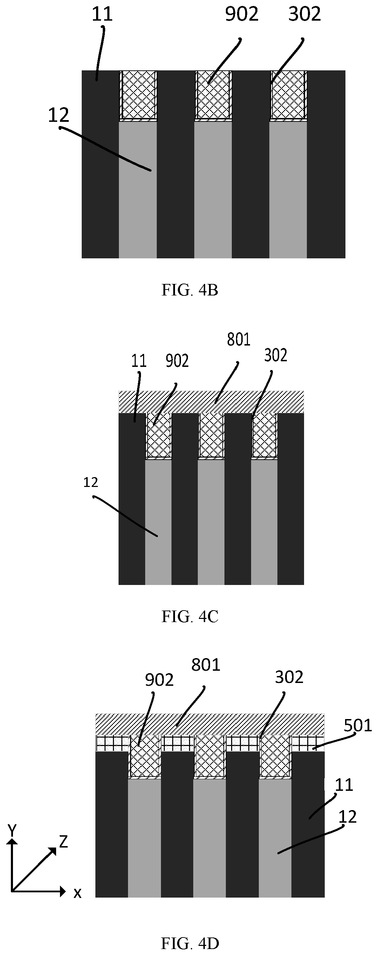

The main differences in the still another embodiment of the present disclosure are described in detail with reference to the drawings. As shown in FIG. 4A to FIG. 4C, after the first dielectric material layer 301 is formed and before a first metal layer 801 is formed, the method further includes: as shown in FIG. 4A, forming a third dielectric material layer 901, where the third dielectric material layer 901 covers the first dielectric material layer 301 and fills up the second groove 202; and as shown in FIG. 4B, removing a portion of the third dielectric material layer 901 and a portion of the first dielectric material layer 301, to expose the top of the active pillar 11, where a remaining portion of the third dielectric material layer 901 serves as a third dielectric layer 902 that is flush with the active pillar 11, a remaining portion of the first dielectric material layer 301 serves as the first dielectric layer 302. Specifically, the portion of the third dielectric material layer 901 and the portion of the first dielectric material layer 301 may be removed by a CMP process. Then, as shown in FIG. 4C, the first metal layer 801 is formed on the top of the third dielectric layer 902 and the active pillar 11.

Then, as shown in FIG. 4D, a heat treatment is performed to form conductive structures 501. As the first dielectric layer 302 covers the side walls of the active pillars 11, when the conductive structures 501 are being generated through the reaction between the first metal layer 801 and the active pillars 11, the first dielectric layer 302 protects the side walls of the active pillars 11, to prevent the defective bigger-head shape shown in FIG. 1C caused by expansion due to the reaction between the active pillars 11 and the first metal layer 801. In this way, the appearance of the side walls of the conductive structures 501 can be relatively vertical, improving the performance of the conductive structures 501, and facilitating subsequent processes.

As a temperature for forming the first dielectric layer 302 is higher than a temperature for the heat treatment, specifically, the temperature for forming the first dielectric layer 302 is higher than 500°C, and the temperature for the heat treatment is not higher than 500°C. As shown in FIG. 1C and FIG. 1D above, in the case that the conductive structures are formed before the first dielectric layer is formed, as the temperature for forming the first dielectric layer is higher than the temperature for the heat treatment, the conductive structures can further react at the high temperature, to convert a material of the conductive structures from a low resistance substance to a high resistance substance. That is, the conductive structures in a low resistance state are converted into conductive structures in a high resistance state. This leads to a higher resistance of the conductive structures, affecting the performance of the conductive structures. However, in the embodiments of the present application, the formation of the first dielectric layer 302 is prior to the formation of the conductive structures 501, that is, the first dielectric layer 302 is formed before the conductive structures 501 are formed, and the reaction of the first dielectric layer 302 at the high temperature does not affect the subsequent formation of the conductive structures 501, such that the material of the conductive structures 501 is not converted from the low resistance substance to the high resistance substance, thereby preventing the resistance of the conductive structures 501 from increasing, and improving the performance of the conductive structures 501.

Specifically, the conductive structures 501 may be made of one or more of titanium silicide (TiSi), tantalum silicide (TaSi), nickel silicide (NiSi), and cobalt silicide (CoSi). Optionally, the conductive structures 501 are made of nickel silicide (NiSi). Specifically, with poor thermal stability, NiSi starts to agglomerate at a temperature higher than 500°C, and low resistance NiSi starts to convert into high resistance NiSi2. Specifically, the resistivity of NiSi is not greater than 20 µΩ·cm, and the resistivity of NiSi2 ranges from 24 µΩ·cm to 30 µΩ·cm. The conversion of the NiSi thin film from low resistance NiSi to high resistance NiSi2 can seriously affect the contact characteristics between the metal and the semiconductor, sharply increasing the contact resistance and lowering the performance of the device. Therefore, according to the present application, the first dielectric layer 302 with the high reaction temperature is formed before the conductive structures 501 are formed, to prevent the conductive structures 501 from being converted from low resistance NiSi to high resistance NiSi2, such that the resistance of the conductive structures 501 can be reduced, the contact resistance between the metal and the semiconductor can be further reduced, and the performance of the device can be improved.

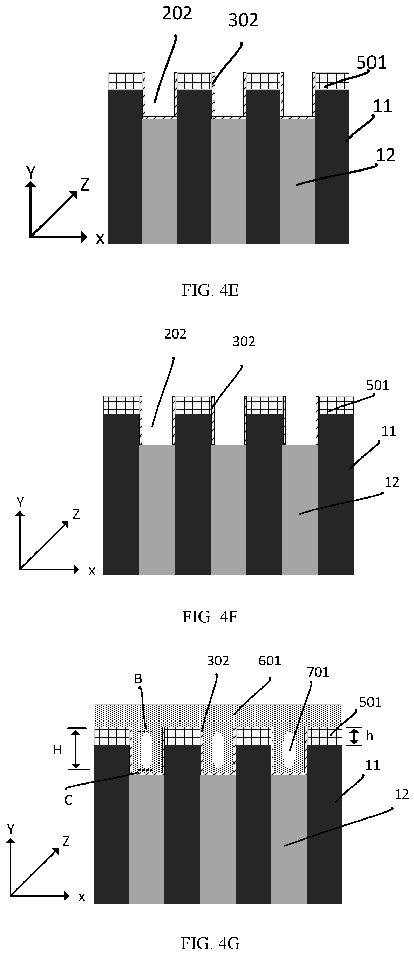

Then, as shown in FIG. 4E and FIG. 4F, after the conductive structures 501 are formed, the method further includes: removing the first metal layer 801 and the third dielectric layer 902, to expose the second groove 202. Specifically, as shown in FIG. 4E, the first metal layer 801 and the third dielectric layer 902 may be removed by a wet etching process. In a specific embodiment, the first metal layer 801 may be first removed by wet etching, and the third dielectric layer 902 may be then removed by wet etching; or in another specific embodiment, the first metal layer 801 may be removed by CMP, and the third dielectric layer 902 may be then removed by wet etching. As shown in FIG. 4F, after the first metal layer 801 and the third dielectric layer 902 are removed, a portion of the first dielectric layer 302 at the bottom of the second groove 202 may be further removed, where a remaining portion of the first dielectric layer 302 covers only the side walls of the second groove 202, the first dielectric layer 302 covers the side walls of the conductive structures 501, and the depth of the first dielectric layer 302 in the second direction Y is greater than the depth of the conductive structure 501 in the second direction Y.

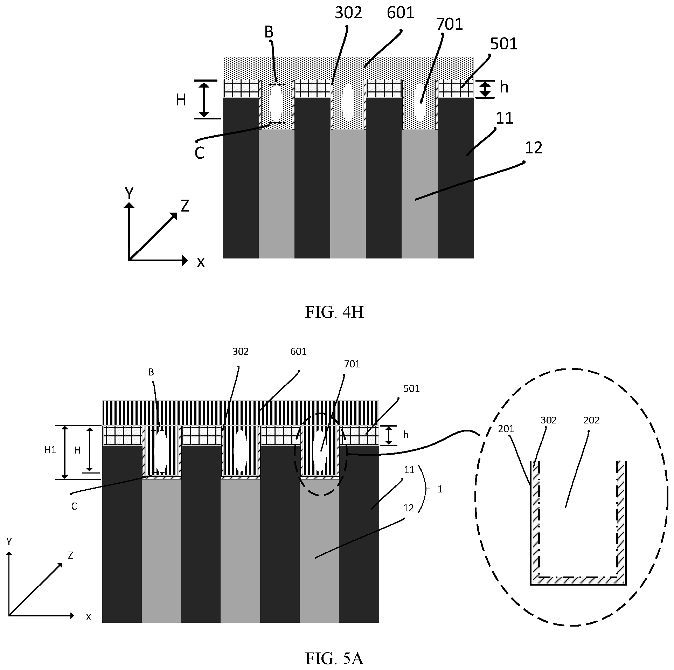

Then, as shown in FIG. 4G and FIG. 4H, a second dielectric layer 601 fills the second groove, and the second dielectric layer 601 not only fills the second groove, but also covers the top of the conductive structure 501. As shown in FIG. 4G, the first dielectric layer 302 is provided between the second dielectric layer 601 and each of the isolation layers 12; and as shown in FIG. 4H, the first dielectric layer 302 is not provided between the second dielectric layer 601 and the isolation layer 12, that is, the second dielectric layer 601 is in direct contact with the isolation layer 12.

Specifically, the second dielectric layer 601 may or may not have air gaps therein. Optionally, as shown in FIG. 4G and FIG. 4H, the second dielectric layer 601 has air gaps 701 therein, and the depth of each of the air gaps 701 in the second direction Y is greater than the depth of the conductive structure 501. In the present application, the depth of the first groove 201 is greater than the depth of the conductive structure 501, making it possible that the depth of the air gap 701 in the second direction Y is greater than the depth of the conductive structure 501. The depth h of the conductive structure refers to the depth measured from the top surface of the conductive structure to the very bottom of the conductive structure. As shown in the figure, the air gap 701 is provided with a top part B and a bottom part C, the top part B of the air gap 701 is lower than the top surface of the conductive structure 501, but is higher than the bottom surface of the conductive structure 501, the bottom part C of the air gap 701 is lower than the bottom surface of the conductive structure 501, and the depth H of the air gap 701 refers to the height measured in a direction from a point parallel to the top surface of the conductive structure 501 toward the bottom part C of the air gap, as shown by H in FIG. 3G and FIG. 3H. Further, the size of the air gap 701 in the second direction Y is 2/3 to 3/4 of the depth of the second groove 202, and the maximum size of the air gap in the first direction X is 1/3 to 3/4 of the width of the second groove 202. This arrangement allows the air gap 701, as placed between the conductive structures 501, to reduce the parasitic capacitance between the conductive structures 501. In addition, the dielectric constant of the first dielectric layer 302 is less than the dielectric constant of each of the active pillars, and the material of the first dielectric layer 302 includes, but is not limited to, silicon oxide, silicon nitride, silicon oxynitride, carbon-doped silicon oxide, or another suitable material, where the first dielectric layer 302 may be carbon-doped silicon oxide in the embodiments of the present application; and the main material of the active pillar is silicon, where the dielectric constant of silicon is 11 to 12, the dielectric constant of the carbon-doped silicon oxide is about 4.5, and the dielectric constant of the first dielectric layer 302 is less than the dielectric constant of the active pillar, such that the parasitic capacitance of the semiconductor structure can be further reduced.

According to the embodiments of the present application, through process optimization and improvement, the first dielectric layer 302 with the high reaction temperature is formed before the conductive structures 501 are formed, to prevent the conductive structures 501 from being converted from low resistance NiSi to high resistance NiSi2, such that the resistance of the conductive structures 501 is reduced. Further, the first dielectric layer 302 can prevent the conductive structures 501 from having a bigger-head shape and from being further damaged during etching. Moreover, the dielectric constant of the first dielectric layer 302 is less than the dielectric constant of the active pillar 11, such that the parasitic capacitance of the device is reduced. To further reduce the parasitic capacitance, the air gap may be further arranged between the conductive structures 501. As the relative dielectric constant of the air is about 1, the air can be used as a good dielectric medium, to further reduce the parasitic capacitance between the conductive structures 501. Through all the foregoing improvements, the performance and the yield of the semiconductor device can be improved.

FIG. 5A is a schematic structural diagram of a semiconductor structure according to an embodiment of the present disclosure.

The semiconductor structure according to the present disclosure includes: a base substrate 1, where the base substrate 1 is provided with active pillars 11 and isolation layers 12 spaced apart along a first direction X, the active pillars 11 and the isolation layers 12 all extend along a second direction Y, the first direction X is parallel to the surface of the base substrate 1, the second direction Y is parallel to the thickness direction of the base substrate 1, and the second direction Y is perpendicular to the first direction X; and conductive structures 501 electrically connected to the active pillars 11, where the conductive structures 501 extend along a third direction Z, and the third direction Z is perpendicular to the first direction X and the second direction Y. Specifically, the active pillars 11 are spaced apart along both the first direction X and the third direction Z, and the active pillars 11 are isolated from each other by the isolation layers 12. The first groove 201, as indicated by solid lines in the enlarged view, is located between adjacent conductive structures 501. The second groove 202, as indicated by dotted lines in the enlarged view, is located in the first groove 201. The first dielectric layer 302 is located between the first groove 201 and the second groove 202, where the first dielectric layer 302 covers at least the side walls of each of the conductive structures 501; and a second dielectric layer 601 fills the second groove 202 and covers the top of each of the conductive structures 501.

As shown in FIG. 5A, the first dielectric layer 302 is located at the bottom and on the side walls of the first groove 201. In a specific embodiment, the first dielectric layer 302 may be located only on the side walls of the first groove 201.

Specifically, the dielectric constant of the first dielectric layer 302 is less than the dielectric constant of each of the active pillars 11; and the depth H1 of the first groove 201 is greater than the depth h of the conductive structure. The depth H1 of the first groove 201 refers to the depth measured to the very bottom of the first groove 201 in a direction parallel to the conductive structure 501, and the depth h of the conductive structure refers to the depth measured from the top surface of the conductive structure to the very bottom of the conductive structure. The resistivity of the conductive structure is not greater than 20 µΩ·cm, and the material of the conductive structure may be NiSi. The second dielectric layer 601 has air gaps 701 therein, and the depth H of each of the air gaps 701 in the second direction Y is greater than the depth h of each of the conductive structures 501. For other similar or corresponding content, reference can be made to corresponding descriptions in the foregoing embodiments.

The first dielectric layer 302 can prevent the conductive structures 501 from having a bigger-head shape and from being further damaged during etching; and can further prevent the conductive structures 501 from being converted from low resistance NiSi to high resistance NiSi2, such that the resistance of the conductive structures 501 is reduced. Moreover, the dielectric constant of the first dielectric layer 302 is less than the dielectric constant of the active pillar 11, such that the parasitic capacitance of the device is reduced. To further reduce the parasitic capacitance, the air gap may be further arranged between the conductive structures 501. As the relative dielectric constant of the air is about 1, the air can be used as a good dielectric medium, to further reduce the parasitic capacitance between the conductive structures 501. Through all the foregoing improvements, the performance and the yield of the semiconductor device can be improved.

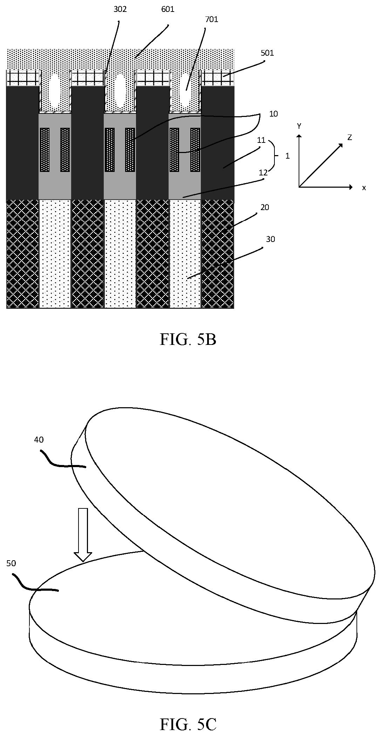

FIG. 5B is a schematic structural diagram of a semiconductor structure according to another embodiment of the present disclosure.

As shown in FIG. 5B, on the basis of FIG. 5A, the base substrate 1 further includes word line structures 10. The word line structures 10 surround the active pillars 11, the active pillars 11 are spaced apart along both the first direction X and the third direction Z, and the active pillars 11 are isolated from each other by the isolation layers 12. One end of each of the active pillars 11 is electrically connected to each of the conductive structures 501, the conductive structures 501 may be bit line structures, another end of the active pillar 11 is electrically connected to a capacitor structure 20, and adjacent capacitor structures are isolated from each other by a fourth dielectric layer 30. The semiconductor structure according to this embodiment may be a gate-all-around (gate-all-around, GAA) structure or a vertical channel transistor (vertical channel transistor, VCT) structure.

FIG. 5C is a schematic structural diagram of a memory device formed by a semiconductor structure bonded to a wafer according to the present disclosure.

As shown in FIG. 5C, the memory device includes a first wafer 40 and a second wafer 50. The first wafer 40 has the semiconductor structure described above, the second wafer 50 includes a control circuit, and the first wafer 40 and the second wafer 50 are bonded to form the memory device.

Those of ordinary skill in the art can understand that the foregoing implementations are specific embodiments of practicing the present disclosure, while in practical application, various changes can be made to the implementations in form and detail without departing from the spirit and scope of the present disclosure. Any person skilled in the art can make various changes and modifications without departing from the spirit and scope of the present disclosure, and the protection scope of the present disclosure shall be defined by the appended claims.

## Claims

1. A method for manufacturing a semiconductor structure, comprising:
providing a base substrate (1), wherein the base substrate (1) is provided with active pillars (11) and isolation layers (12) spaced apart along a first direction (X), the active pillars (11) and the isolation layers (12) all extend along a second direction (Y), the first direction (X) is parallel to a surface of the base substrate (1), the second direction (Y) is parallel to a thickness direction of the base substrate (1), and the second direction (Y) is perpendicular to the first direction (X);
removing a portion of each of the isolation layers (12) to form a first groove (201);
depositing a first dielectric layer (302) at least on side walls of the first groove (201) to form a second groove (202);
forming a first metal layer (401, 801), wherein the first metal layer (401, 801) directly covers at least the active pillars (11);
performing a heat treatment to form conductive structures (501), wherein the first dielectric layer (302) covers side walls of each of the conductive structures (501), the conductive structures (501) extend along a third direction (Z), and the third direction (Z) is perpendicular to the first direction (X) and the second direction (Y); and
forming a second dielectric layer (601), wherein the second dielectric layer (601) fills the second groove (202).

2. The manufacturing method according to claim 1, wherein forming the first dielectric layer (302) specifically comprises:
forming a first dielectric material layer (301), wherein the first dielectric material layer (301) covers the side walls and a bottom of the first groove (201), and a top of each of the active pillars (11); and
removing a portion of the first dielectric material layer (301) on the top of the active pillar (11), wherein a remaining portion of the first dielectric material layer (301) serves as the first dielectric layer (302).

3. The manufacturing method according to claim 1, wherein forming the first dielectric layer (302) specifically comprises:
forming a first dielectric material layer (301), wherein the first dielectric material layer (301) covers the side walls and a bottom of the first groove (201), and a top of each of the active pillars (11); and
removing a portion of the first dielectric material layer (301) on the top of the active pillar (11) and at the bottom of the first groove (201), wherein a remaining portion of the first dielectric material layer (301) serves as the first dielectric layer (302).

4. The manufacturing method according to any one of claim 2 or 3, wherein
the first metal layer (401, 801) fills up the second groove (202) and covers the top of the active pillar (11).

5. The manufacturing method according to any one of claim 2 or 3, wherein after the first dielectric material layer (301) is formed and before the first metal layer (401, 801) is formed, the method further comprises:
forming a second metal material layer (402'), wherein the second metal material layer (402') covers the first dielectric material layer (301) and fills up the second groove (202); removing a portion of the second metal material layer (402') and a portion of the first dielectric material layer (301), to expose the top of the active pillar (11), wherein a remaining portion of the second metal material layer (402') serves as a second metal layer (402) that is flush with the active pillar (11); and
forming the first metal layer (401, 801) on the top of the second metal layer (402) and the active pillar (11).

6. The manufacturing method according to any one of claim 2 or 3, wherein after the first dielectric material layer (301) is formed and before the first metal layer (401, 801) is formed, the method further comprises:
forming a third dielectric material layer (901), wherein the third dielectric material layer (901) covers the first dielectric material layer (301) and fills up the second groove (202); removing a portion of the third dielectric material layer (901) and a portion of the first dielectric material layer (301), to expose the top of the active pillar (11), wherein a remaining portion of the third dielectric material layer (901) serves as a third dielectric layer (902) that is flush with the active pillar (11); and
forming the first metal layer (401, 801) on the top of the third dielectric layer (902) and the active pillar (11).

7. The manufacturing method according to claim 4, wherein after the conductive structures (501) are formed and before the second dielectric layer (601) is formed, the method further comprises:
removing the first metal layer (401, 801), to re-expose the second groove (202).

8. The manufacturing method according to claim 5, wherein after the conductive structures (501) are formed and before the second dielectric layer (601) is formed, the method further comprises:
removing the first metal layer (401, 801) and the second metal layer (402), to re-expose the second groove (202).

9. The manufacturing method according to claim 6, wherein after the conductive structures (501) are formed and before the second dielectric layer (601) is formed, the method further comprises:
removing the first metal layer (401, 801) and the third dielectric layer (902), to re-expose the second groove (202).

10. The manufacturing method according to claim 1, wherein a depth of the first groove (201) is greater than a depth of the conductive structure (501); a dielectric constant of the first dielectric layer (302) is less than a dielectric constant of each of the active pillars (11); and a temperature for forming the first dielectric layer (302) is higher than a temperature for the heat treatment, and a resistivity of the conductive structure (501) is not greater than 20 µΩ·cm.

11. The manufacturing method according to claim 1, wherein the second dielectric layer (601) has air gaps (701) therein, and a depth of each of the air gaps (701) in the second direction (Y) is greater than a depth of the conductive structure (501).

12. A semiconductor structure, comprising:
a base substrate (1), wherein the base substrate (1) is provided with active pillars (11) and isolation layers (12) spaced apart along a first direction (X), the active pillars (11) and the isolation layers (12) all extend along a second direction (Y), the first direction (X) is parallel to a surface of the base substrate (1), the second direction (Y) is parallel to a thickness direction of the base substrate (1), and the second direction (Y) is perpendicular to the first direction (X);
conductive structures (501), electrically connected to the active pillars (11), wherein the conductive structures (501) extend along a third direction (Z), and the third direction (Z) is perpendicular to the first direction (X) and the second direction (Y);
a first groove (201), located between adjacent conductive structures (501);
a second groove (202), located in the first groove (201);
a first dielectric layer (302), located between the first groove (201) and the second groove (202) and covering at least side walls of each of the conductive structures (501); and
a second dielectric layer (601), filling the second groove (202) and covering a top of each of the conductive structures (501).

13. The semiconductor structure according to claim 12, wherein a dielectric constant of the first dielectric layer (302) is less than a dielectric constant of each of the active pillars (11); and a depth of the first groove (201) is greater than a depth of the conductive structure (501).

14. The semiconductor structure according to claim 12, wherein a resistivity of the conductive structure (501) is not greater than 20 µΩ·cm.

15. The semiconductor structure according to claim 12, wherein the second dielectric layer (601) has air gaps (701) therein, and a depth of each of the air gaps (701) in the second direction (Y) is greater than a depth of the conductive structure (501).
